(19)

Europäisches
Patentamt
European
Patent Office
Office européen
des brevets

(11)  **EP 3 385 742 A1**

(12)  # EUROPEAN PATENT APPLICATION

(43) Date of publication:
**10.10.2018  Bulletin 2018/41**

(51) Int Cl.:
*G01R 33/50* (2006.01)        *G01R 33/561* (2006.01)

(21) Application number: **17165079.9**

(22) Date of filing: **05.04.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicants:
• **Fraunhofer-Gesellschaft zur Förderung der
angewandten Forschung e.V.
80686 München (DE)**

• **Julius-Maximilians-Universität Würzburg
97070 Würzburg (DE)**

(72) Inventors:
• **Blaimer, Martin
97074 Würzburg (DE)**
• **Jakob, Peter
97262 Hausen (DE)**

(74) Representative: **Aurigium Leischner & Luthe
Patentanwälte Partnerschaft mbB
Robert-Koch-Straße 2
82152 Planegg (DE)**

(54)  **METHOD AND APPARATUS FOR IDENTIFYING AT LEAST ONE MATERIAL COMPRISED IN A VOXEL**

(57)    The present invention discloses a method (500) for identifying at least one material (115) comprised in a voxel (120). The disclosed MR data acquisition method uses the transient phase of balanced steady-state free precession (bSSFP), which allows to simultaneously acquire quantitative information about longitudinal and transversal relaxation times T1 and T2 and relative proton density in multi-component systems. In one embodiment , these values are derived by combining signals from multiple acquisitions each of whom being realized by radio-frequency excitation pulses with different flip angles.The method is thus suitable for quantitative MRI T1 and T2 mapping. The method comprises a step of Reading in (510) at least a first ($S_1$) and a second ($S_2$) signal train, the first ($S_1$) and second ($S_2$) signal train each representing magnetization values being determined after the material (115) in the voxel (120) was exposed to predefined radio-frequency pulses ($P_1$, $P_2$), wherein the predefined radio-frequency pulses ($P_1$) exposed to the material (115) in the voxel (120) before or during measuring the first signal train ($S_1$) differs in at least one parameter ($\alpha$) from the radio-frequency pulses ($P_2$) exposed to the material (115) in the voxel (120) before or during measuring the second signal train ($S_2$). Furthermore, the method comprises a step of Performing (520) at least a time-domain-frequency-domain transformation, such as e.g. inverse Laplace transformation, in order to obtain a first ($F_1$) and a second ($F_0$) transformation value, the first transformation value ($F_1$) representing a frequency domain signal resulting from the time-domain-frequency-domain transformation on the basis of at least the first signal train ($S_1$) and the second transformation value ($F_0$) representing a frequency domain signal resulting from the time-domain-frequency-domain transformation on the basis of at least the second signal train ($S_2$). Finally the method comprises a step of Specifying (530) the material (115) using the first ($F_1$) and second ($F_0$) transformation values or values derived from the first ($F_1$) and/or second ($F_0$) transformation value, in order to identify the material (115).

Fig. 2B

EP 3 385 742 A1

**Description**

The present invention concerns a method and an apparatus for identifying at least one material comprised in a voxel according to the independent claims. This method can be used for medical MRI or material analysis purposes.

Magnetic resonance (MR) has become a very powerful tool for biomedical diagnosis and material testing. This can be attributed to the fact, that each material (e.g. biological tissue type or synthetic material) has unique relaxation time constants $T_1$ and $T_2$, also known as longitudinal and transverse relaxation times respectively. When there are multiple materials in a voxel, $T_1$ and $T_2$ relaxation time distributions (i.e. spectra) can be obtained independently with two measurements, e.g. using an inversion-recovery (IR) FLASH sequence for generating a $T_1$ spectrum or a Carr-Purcell-Meiboom-Gill (CPMG) sequence for generating a $T_2$ spectrum.

However, a correlation between the $T_1$ and $T_2$ values is not possible in that way. In other words, when there are multiple peaks in the spectra it is not possible to determine which $T_2$-value correlates to which $T_1$-value or conversely, which $T_1$-value correlates to which $T_2$-value. Therefore, $T_1$-/$T_2$- correlation measurements are highly preferred for a better identification of material or tissue types. In principle, this is possible with the IR-CPMG method but requires significantly longer scan times. For example, typically a plurality of measurements (e.g. N = 32) with different system setting (e.g. inversion times TI) need to be performed. Each individual measurement takes several seconds and therefore, the overall scan time is on the order of several minutes depending on the desired accuracy.

Biomedical imaging applications typically assume a single material in a voxel when performing $T_1$- and $T_2$-measurements. Multi-compartment modeling may be used for simultaneously quantifying the $T_1$- and $T_2$- values for a limited number of tissue types that are assumed to be within a voxel. However, this approach works only for specific applications (e.g. myelin mapping in the human brain), requires prior knowledge about the disease and works only for a limited number of compartments.

Disclosure of the Invention

In this context, according to a embodiment of the present invention the present invention provides a method for identifying at least one material comprised in a voxel, the method comprising the following steps:

Reading in at least a first and a second signal train, the first and second signal train each representing magnetization values being determined after the material in the voxel was exposed to predefined radio-frequency pulses wherein the predefined radio-frequency pulses exposed or applied to the material in the voxel before or during measuring the first signal train differs in at least one parameter from the radio-frequency pulses exposed or applied to the material in the voxel before or during measuring the second signal train;

- Performing at least a time-domain-frequency-domain transformation in order to obtain a first and a second transformation value, the first transformation value representing a frequency domain spectrum resulting from the time-domain-frequency-domain transformation on the basis of at least the first signal train and the second transformation value representing a frequency domain spectrum resulting from the time-domain-frequency-domain transformation on the basis of at least the second signal train;

or
Performing at least a time-domain-frequency-domain transformation in order to obtain a first and a second transformation value, the first transformation value representing a frequency domain spectrum resulting from the time-domain-frequency-domain transformation on the combination of the first and second signal trains and the second transformation value representing a frequency domain spectrum resulting from a different combination of the first and second signal trains;
and

- Specifying the material using the first and second transformation values or values derived from the first and second transformation value, in order to identify the material.

A material can be considered to be a biological tissue, for example from a human, an animal or a plant. Alternatively or additionally the material can also be an object or material which has to be identified in a material analysis. Identifying a material can be considered to be a determination of the type of material or of the molecular composition of the material in the voxel, wherein the voxel defines a predefined volume unit at a predefined location in an object or the body. A radio-frequency pulse can be considered to be a magnetic field, especially an oscillating magnetic field, which is superimposed on or applied to the material of the voxel and which turns a magnetic spin of the material of the voxel into predefined directions. A time-domain-frequency-domain transformation can be considered a mathematical operation in which a signal is transformed from the time domain into the frequency domain. Thus, the signal is acquired in the time domain and is transformed in the frequency domain, which can also be understood as a spectral domain such that the time-domain-frequency-domain transformation can be understood as a time-domain-spectral-domain transformation. For example an inverse Laplace transformation or a Fourier transformation can be considered to be such time-domain-frequency-domain transformations.

In order to perform the invention explained in this description a signal train is measured using radio-frequency excitation pulses for example. Before the signal train, one or more radio-frequency preparation pulse may be applied to produce a pre-defined initial magnetization value of the sample (e.g. inverting the sign of the magnetization).

The present invention is based on the finding that said time-domain-frequency-domain transformation provides a very powerful tool to identify the material on the basis of the first and second transformation values, which themselves are based on two steady-state-free-precession (SSFP) signal trains (or the combination thereof) which are measured when different radio-frequency pulses are exposed or applied to the material in the voxel. Due to the radio-frequency pulses, which differ in at least one parameter as for example in orientation, duration, or a strength of the oscillating magnetic field (resulting in a pre-defined flip angle), applied to the material in the voxel said transformation provides an efficient way in collecting information which can then be used and processed for the identification of the material of the voxel. The invention thus provides the advantage to identify the material very quickly with the minimum of necessary measurement information in contrast of state-of-the-art and with normal numeric effort.

According to a preferred embodiment of the present invention in the step of reading in, a second signal train is read in, in which the parameter of the radio-frequency preparation pulse exposed to the material in the voxel for measuring the second signal train differs in a amplitude, duration or a orientation from a radio-frequency preparation pulse exposed or applied to the material in the voxel for measuring the first signal train, especially in which the radio-frequency preparation pulse exposed to the material in the voxel for measuring the second signal train produces an inversion of the magnetization of the material. Such an embodiment of the present invention provides the advantage that those parameters can be easily measured respectively adjusted such that the identification of the material can be precisely accomplished with little technical effort. Furthermore, such a modification of the radio-frequency pulses has a significant impact on signals which are used for the identification of the material in the voxel.

Additionally or alternatively the parameter of the radio-frequency excitation pulse train exposed or applied to the material in the voxel for measuring the second signal train differs by the flip-angle of the radio-frequency excitation pulse train applied to the material in the voxel for measuring the first signal train. Such an embodiment of the present invention provides the advantage that those parameters can be easily measured respectively adjusted such that the identification of the material can be precisely accomplished with little technical effort. Furthermore, such a modification of the radio-frequency pulses has a significant impact on signals which are used for the identification of the material in the voxel.

According to a further embodiment of the present invention the step of performing comprises performing a time-domain-frequency-domain transformation of terms obtained by a summation and/or a subtraction of the first and second signal trains in order to obtain the first and second transformation values. Thus, the term used as a input for the transformation can be considered to be a sum or a difference of the first and second signal trains. Such a combination of the first and second signal trains prior to the performance of the transformation provides the advantage of an identification of the materials in the voxel based on analytical calculations.

Very little numerical effort has to be taken, if, according to a further embodiment, the step of performing comprises performing an inverse Laplace Transformation and/or a Fourier Transformation, and/or if the step of performing comprises performing a unidimensional time-domain-frequency-domain transformation. The performance embodiments using such a transformation provides the advantage of performing well known and thus numerically optimized transformation algorithms in order to obtain the first and second transformation values.

According to a further embodiment of the present invention the step of performing comprises at least determining a local maximum of the first and/or second transformation value, especially determining a value, at which the local maximum of the first and/or second transformation value is obtained. Such an embodiment of the present invention provides the advantage that the determination of a local maximum of the first and/or second transformation value provides information on a time constant for the signal train approaching the steady-state after the material in the voxel is exposed to the radio-frequency excitation pulses and from which the identification of the material or the type of material in the voxel can uniquely be drawn. Thus, the local maximum provides a very strong information on determining a longitudinal relaxation value and a transverse relaxation value, which themselves provides an easy and precise identification of the material in that voxel.

In a further embodiment of the present invention, the step of performing comprises a calculation of a longitudinal relaxation value and a transverse relaxation value on the basis of the first and/or second transformation values, especially on the basis of a value, at which the local maximum of the first and/or second transformation value is obtained. Such an embodiment of the present invention provides the advantage of a precise and rapid identification of the material due to the fact that each material has unique values of longitudinal and transverse relaxation values, respectively a unique correlation of longitudinal and transverse relaxation values.

According to another embodiment of the present invention, the step of performing comprises computing an inverse or pseudoinverse of a matrix comprising information about different flip angles used for the radio-frequency excitation pulses applied to the material of the voxel. Such an embodiment provides the advantage of performing an algorithm which can be accomplished in a compact and numerically easy way such that the identification of the material in the voxel is determined quickly.

A very precise and rapid determination of the material in the voxel can be accomplished according to a further embodiment of the present invention in which the step of specifying comprises identifying the material on the basis of at least one correlation of a longitudinal relaxation value and a transverse relaxation value. The identification of the material can, for example, be performed on the basis of a comparison of the (measured or calculated) correlation of the longitudinal relaxation value and the transverse relaxation value with respect to a pre-defined correlation of longitudinal and transverse relaxation values which are, for example, taken from a lookup table. In this lookup table a specific correlation of the longitudinal relaxation value and the transverse relaxation value can be stored which then provides the basis for identification of the specific material under consideration. Therefore, such an embodiment of the present invention provides the advantage of a rapid and still precise determination of the material in the voxel.

Furthermore, the identification accuracy of the material can still be optimized, if according to a further embodiment of the present invention the step of specifying comprises identifying the material on the basis of a proton density value, being read in or being calculated from the first and/or second transformation values or values derived from the first and/or second transformation value. The proton density value provides further information which can be advantageously used for precise identification and determination of the quantity of the distinct material in the voxel. The proton density value can be read in for example from a specific sensor or be calculated from the values already determined or processed in the steps of the method disclosed herein.

In order to precisely determine the proton density of the material in the voxel, according to a further embodiment of the present invention the step of specifying comprises identifying the material on the basis of signal train values at the start (i.e. at time t=0 after the radio-frequency preparation pulses) and in the steady state of the signal train , the flip angle of the radio-frequency excitation pulses and the longitudinal and transverse relaxation values $T_1$ and $T_2$. The usage of such parameters of the present invention provides the advantage that these parameters can be easily measured or adjusted in a sensor device such that the identification of the material can be easily, rapidly and precisely accomplished.

Furthermore, the present invention also provides an apparatus being configured for performing, controlling or executing the steps of an embodiment of the here disclosed method in respective units.

The apparatus can presently be considered as an electrical device which is configured to process sensor signals and, dependently thereof, provide control and/or data signals. The sensor signals can for example be signals of a sensor of a medical device respectively of the sensor which is embedded in a medical device. The sensor signals can be considered the sensor signals of a magnetic resonance sensor. The control, data and/or sensor signals can be considered to be signals which are provided to a control or processing unit which is configured to perform the above-mentioned method in separate instances or subunits. Such subunits can, for example, be configured as signal processors or microcontrollers which are capable of performing mathematical algorithms.

Furthermore, an embodiment of the present invention implemented as a computer program project or computer program with program code provides advantages, wherein the computer program product or the computer program with program code is stored on a machine readable carrier for a storage medium as for example a semiconductor storage, a disk storage or an optical storage. The computer program product or the program with program code can be configured for performing and/or controlling the steps of the method according to a previously described embodiment of the present invention, especially if the program product or program is run on a computer or a respectively configured apparatus.

Embodiments of the approach presented here are described and depicted in detail with respect to the following figures and description. Shown is in

Figure 1      a schematic view of a medical device comprising an apparatus according to an embodiment;

Figure 2A      two sequence diagrams for acquiring two signal trains according to a first embodiment of the present invention;

Figure 2B      a schematic of the three basics steps (depicted in the subfigures I, II and III) for fast $T_1$- $T_2$- correlation measurements based on balanced SSFP with and without radio-frequency inversion pulse according to a first embodiment of the present invention;

Figure 3      a diagram for generation of a correlation $T_1$- / $T_2$- spectrum from two $T_1^*$ spectra obtained from two balanced SSFP measurements (with and without radio-frequency inversion pulse) according to the first embodiment of the present invention;

Figure 4A      two sequence diagrams for acquiring two signal trains according to a second embodiment of the present invention;

Figure 4B-D      in three subfigures 4B, 4C and 4D results from a Proof-of-Principle measurement according to the second embodiment of the present invention; and

Figure 5      a flow diagram of a method for identifying at least one material comprised in a voxel according to an embodiment of the present invention.

Same or equal elements are denoted by same or equal reference numerals, wherein a repeated description is omitted due to clarity reasons.

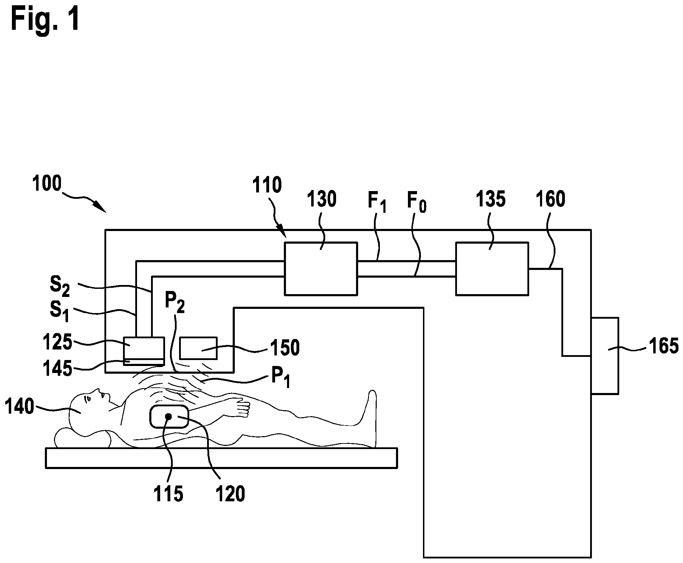

Figure 1 shows a schematic view of a medical device 100 comprising an apparatus 110 according to an embodiment of the approach presented here. Although the present invention is disclosed in the following description with respect to medical device 100 it is obvious that the invention can be comprised in an apparatus for material analysis, as for example for forensic or material inspection purposes.

The apparatus 110 for identifying at least a material 115 in a voxel 120 comprises an interface or unit 125 for reading in, a unit 130 for performing and a unit 135 for specifying. The voxel 120 can be a volume unit of a predefined size and a predefined location of a human body 140 for example. The unit 125 for reading in is configured for reading in at least a first signal train S1 and a second signal train S2, wherein the first signal train S1 and the second signal train S2 each represent magnetization values of the materials in the voxel (120) which is measured by a (magnet field sensing) sensor 145. The first signal train S1 is specifically measured, after the material 115 in the voxel 120 was exposed to the predefined (first) radio-frequency pulse P1 being sent out from a first magnet emitter 150. The second signal train S2 is specifically measured, after the material 115 in the voxel 120 was exposed to the predefined (second) radio-frequency pulse P2, being sent out from the magnet emitter 150. In this context it is noted that the first radio-frequency pulse P1 differs in at least one parameter from the second radio-frequency pulse P2. For example, the first radio-frequency pulse P1 has a different duration, amplitude or orientation with respect to the magnetic field sent out as the second radio-frequency pulse P2. However as the second radio-frequency pulse P2 is sent out at a time interval after the first radio-frequency pulse P1 it is also possible that the second radio-frequency pulse P2 is sent out by the first magnet emitter 150 with different parameter settings as the sending of the first radio-frequency pulse P1 by the magnet emitter 150.

The apparatus 110 further comprises said unit 130 for performing. In this unit 130 for performing at least a time-domain-frequency-domain transformation is performed in order to obtain a first transformation value $F_1$ and/or a second transformation value $F_0$. The first transformation value $F_1$ represents a frequency domain spectrum resulting from the time-domain-frequency-domain transformation on the basis of at least the first signal train $S_1$. The second transformation value $F_0$ represents a frequency domain spectrum resulting from the time-domain-frequency-domain transformation on the basis of at least the second signal train $S_2$. However, the first transformation value $F_1$ can be also obtained by said transformation on the basis of a combination of the first $S_1$ and second $S_2$ signal trains, for example a sum of the first and second signal trains. The second transformation value $F_0$ can also be obtained by said transformation on the basis of a combination of the first and second signal trains, for example a difference of the first and second signal trains.

Finally, the apparatus 110 comprises said unit 135 for specifying the material on the basis of the first transformation value $F_1$ and/or the second transformation value $F_0$ or values derived from the first transformation value $F_1$ and/or to second transformation value $F_0$, in order to identify the material. To be more specific, the unit 135 for specifying is capable of detecting specific molecule or alloy as material in the voxel 120 in order to identify of the material.

The information of the identified specific material can then be output as a material signal 160, which can then be displayed at a respective display unit 165 in order to visualize the identified material in the voxel 120.

The present invention can also be accomplished for on the voxels located at the other positions in the body 140 as the voxel 120 according to Figure 1 in the human body 140 or for the voxel 120 at the location shown in Figure 1 repeatedly.

In the subsequently following paragraphs specific embodiments of the present inventions are disclosed in more detail.

Disclosed herein is a time-efficient data acquisition method and corresponding data analysis technique for measuring the correlated magnetic resonance (=MR) relaxation time parameters $T_1$ and $T_2$ of at least one material. The MR data acquisition method uses the transient phase of balanced steady-state free precession (bSSFP) measurements being accomplished by the sensor 145 shown in Figure 1. Especially the combination of only two measurements provides the parameters for calculating the correlated $T_1$- and $T_2$-values and the quantity (i.e. relative proton densitiy) of a material in a multi-component sample allowing for a fast and more accurate identification of biological or synthetic materials. In combination with spatial encoding by magnetic field gradients and dedicated image reconstruction algorithms, spatially resolved $T_1$- and $T_2$- correlation measurements respectively calculations can be performed enabling patient exams within clinically acceptable measurement times.

In clinical magnetic resonance imaging (=MRI), the quantitative mapping of $T_1$ and $T_2$ constants offers several advantages over standard MRI. The quantitative information about $T_1$ and $T_2$ may allow for an improved biomedical diagnosis by identifying biomarkers of potential interest. Furthermore, quantitative MRI (qMRI) approaches are of special interest for multi-centric studies because the $T_1$ and $T_2$ values should not depend on the particular MR system on which they were acquired. So far, quantitative $T_1$ and $T_2$ mapping requires long measurement times and is not applied in clinical routine exams.

A very time-efficient qMRI approach is the inversion-recovery balanced steady-state free precession (IR-bSSFP) technique (also known as IR-TrueFISP) which allows to simultaneously acquiring 2D quantitative information about $T_1$, $T_2$ and relative proton density ($M_0$) within a few seconds per slice. One major limitation of IR-TrueFISP and many other qMRI approaches is the assumption of a single material or tissue type within the volume of interest (also known as voxel). However, typically there exist several material components with different $T_1$ and $T_1$, $T_2$ values within one voxel (e.g. fat and water). The acquisition of correlated $T_1$- and $T_2$-distributions (i.e. $T_1$- / $T_2$- spectra) represents a more accurate way for identifying/characterizing different tissues or material types. The two axes of such a spectrum represent all possible $T_1$ and $T_1$, $T_2$ values and each individual peak in the correlated spectrum can be attributed to a unique $T_1$-/$T_2$-combination originating from a distinct material.

A widely used technique for measuring correlated $T_1$-/$T_2$- spectra is the inversion-recovery (IR) multi-spin-echo (MSE, also known as CPMG) method. However, multiple IR-CPMG measurements with different instrument settings (e.g. different times of inversion, TI) are required for obtaining accurate spectra. Due to the very long measurement times, the IR-CPMG approach is far from being applied in biomedical routine exams.

Instead, the IR-CPMG method is widely used for characterizing biological or synthetic materials such as plastic, oils or biological fluids. However, the long scan times prevent the application of IR-CPMG for inline testing which requires short measurement times to assure high throughput.

In summary, the acquisition of correlated quantitative $T_1$ and $T_2$ information allows for an accurate identification of multiple materials within a voxel. However, the long measurement times prevent clinical applications as well as inline material testing of synthetic or biological materials.

Here, an embodiment of the present invention is presented for fast MR relaxography that allows to generate correlated $T_1$-/$T_2$ spectra with only two measurements using the bSSFP (a.k.a. TrueFISP) sequence, an approach which is highly time efficient compared to the state-of-the-art.

In bSSFP, radio-frequency (RF) excitation pulses are repeatedly applied with pre-defined amplitudes (e.g. to achieve a flip angle alpha = 40°) and with constant time interval (repetition time, TR) of a few milliseconds (e.g. TR = 4 ms) to produce a signal train. After several RF pulses, the signal train approaches a steady state. This phase of approaching the steady state is called transient phase and can be characterized by the following equation:

$$S_{bssfp}(t) = S_{stst} - (S_{stst} - S_{0,start}) \cdot \exp(-t/T_1{}^*) \qquad \text{[Equation 1]}$$

$S_{0,start}$ characterizes the initial signal at time t=0, $S_{stst}$ is the steady-state signal and $T_1{}^*$ represents the time constant for approaching the steady-state. For a sufficient characterization of the transient phase, the duration of the signal trains should be on the order of 5·T1.

Assuming a single tissue type (i.e. a material according to the wording in the description of the inventive approach) within the voxel, it has been shown that the material parameters $T_1$, $T_1$, $T_2$ and $M_0$ can be computed from $S_{stst}$, $S_{0,start}$ and $T_1{}^*$, for example when $S_{0,start} = -S_0$. Such a initial signal may be achieved by a magnetization preparation (as radio-frequency pulse) using an inversion RF pulse. The relationship between the material parameters ($T_1$, $T_1$, $T_2$ and $M_0$) and the measurement parameters derived from the signal train ($S_0$, $S_{stst}$ and $T_1{}^*$) are given by:

$$T_1 = T_1{}^* \cdot \frac{S_0}{S_{stst}} \cdot \cos(\alpha/2) \qquad \text{[Equation 2a]}$$

$$T_2 = T_1{}^* \cdot \sin^2(\alpha/2) \cdot \left(1 - \frac{S_0}{S_{stst}} \cdot \cos(\alpha/2)\right)^{-1} \qquad \text{[Equation 2b]}$$

$$M_0 = \frac{S_0}{\sin(\alpha/2)} \qquad \text{[Equation 2c]}$$

In principle, one may obtain a $T_1{}^*$ spectrum from the measured signal train. To that end, according to one embodiment of the present invention the steady-state signal value is subtracted so that the magnitude of the signal represents a multi-exponential decay. Afterwards, a $T_1{}^*$ spectrum may be obtained by applying the inverse Laplace transform to the resulting signal train. However, it is not possible to compute correlated $T_1$- and $T_2$-values from a single $T_1{}^*$ spectrum, because $S_0$ and $S_{stst}$ cannot be obtained from a single spectrum. Instead, the amplitude of the peaks in such a $T_1{}^*$ spectrum is a combination of both $S_0$ and $S_{stst}$.

To be more specific, the relationship between a set of relaxation decay S(t) data and the relaxation time distribution $F(T_i)$ is known in the state of the art by the integral equation:

$$S(t_k) = \int_{T\min}^{T\max} F(T_i) \cdot K(t_k, T_i) dT_i$$

Here, $t_k$ is the time point for measuring the signal $S(t_k)$ and $T_i$ may represent the relaxation time constants $T_1$, $T_1$, $T_2$ or $T_1{}^*$. Formally, this is a Laplace transformation. For the classic Laplace expression, the kernel $K(t_k, T_i)$ describes an exponential decay and has the form $F(t_k, T_i) = \exp(-t_k/T_i)$. However, other kernels can be used, for example for an inversion recovery experiment for $T_1$ measurements, the kernel has the form $F(t_k, T_i) = 1- 2\exp(-t_k/T_i)$. The relaxation time distribution $F(T_i)$ can also be called a spectrum or probability distribution of relaxation rate constants $R_i = 1/T_i$.

To obtain the relaxation time distribution $F(T_i)$, the inverse Laplace transform (ILT) is used to solve the above mentioned equation. To that end, this above mentioned equation is typically converted into a system of linear algebraic equations by numerical integration and then solved using a non-negative least-squares fitting algorithm.

However, it has been realized that correlated $T_1$- and $T_2$-values can be obtained from only two measurements (N=2) with a bSSFP sequence. In the following, two implementations are described as specific embodiments of the present invention.

First embodiment:

In the first implementation or embodiment, one measurement is performed with inversion RF preparation pulse and a second measurement is performed without inversion RF preparation pulse prior to the bSSFP sequence. Other sequence parameters are kept identical.

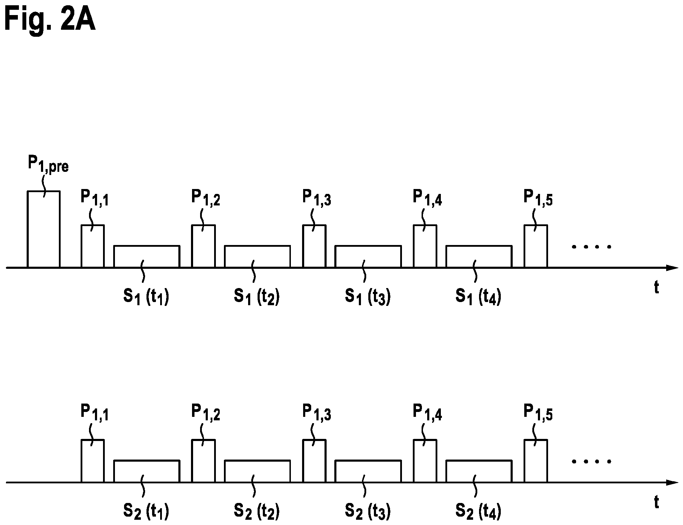

Figure 2A shows two sequence diagrams for acquiring two signal trains $S_1$ and $S_2$ according to the first embodiment. Prior to the first measurement, a radio-frequency preparation pulse $P_{1,pre}$ is applied to invert the magnetization of the spins in the material, which can be seen from the upper diagram of Figure 2A. Radio-frequency excitation pulses $P_{1,n}$ (with n=1, ..., N) producing flip angles $\alpha_{1,n}$ are applied to the material to generate the corresponding signals $S_1(t_n)$. Prior to the second measurement (as shown in the bottom diagram of Figure 2A), no radio-frequency preparation pulse is applied. The signal train $S_2(t_n)$ is produced by the same radio-frequency excitation pulses $P_{1,n}$ as in the first measurement.

The signal train for the first measurement with inversion pulse is characterized by

$$S_1(t) = S_{stst} - (S_{stst} + S_0) \cdot \exp(-t/T_1{}^*) \qquad \text{[Equation 3]}$$

The signal train for the second measurement without inversion pulse is characterized by

$$S_2(t) = S_{stst} - (S_{stst} - S_0) \cdot \exp(-t/T_1{}^*) \qquad \text{[Equation 4]}$$

One special aspect of an embodiment of the present invention is the combination of the measured signal trains. The summation of the first measurement (Equation 3) and the second measurement (Equation 4) yields:

$$S_{add}(t) = S_1(t) + S_2(t) = 2 \cdot S_{stst} \cdot (1 - \exp(-t/T_1{}^*)) \qquad \text{[Equation 5]}$$

The signal train $S_{add}(t)$ depends only on $S_{stst}$, $T_1{}^*$ and time t. The subtraction of the first measurement (Equation 3) from the second measurement (Equation 4) yields:

$$S_{sub}(t) = S_2(t) - S_1(t) = 2 \cdot S_0 \cdot \exp(-t/T_1{}^*) \qquad \text{[Equation 6]}$$

The signal train $S_{sub}(t)$ depends only on $S_0$, $T_1^*$ and time t. Afterwards, an inverse Laplace transform may be applied to the resulting signal trains to obtain two $T_1^*$ spectra: the inverse Laplace transform applied to the signal train $S_{add}$ yields $T_1^*$ as a function of $S_{stst}$ and the inverse Laplace transform applied to the signal train $S_{sub}$ yields $T_1^*$ as a function of $S_0$. In that way the parameters $S_0$ and $S_{stst}$ can be obtained for each $T_1^*$ value allowing to compute the sought-after parameters $M_0$, $T_1$ and $T_2$.

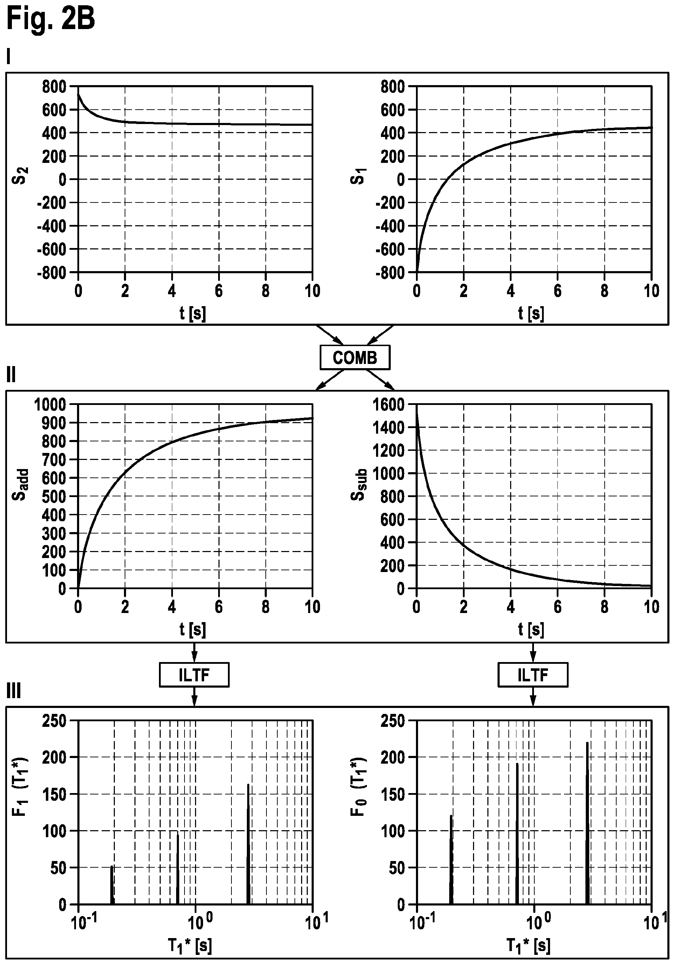

Figure 2B shows a schematic of the three basics steps (depicted in the subfigures I, II and III) for fast $T_1$- $T_2$- correlation measurements based on bSSFP with and without inversion pulse according to a first embodiment of the present invention.

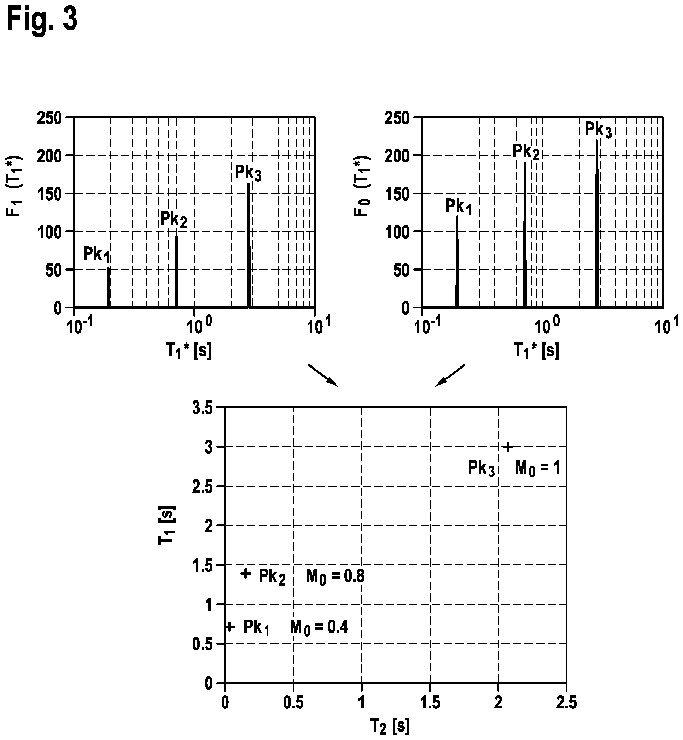

Figure 3 shows a diagram for generation of a correlation $T_1$- / $T_2$- spectrum from two $T_1^*$ spectra obtained from two bSSFP measurements (with and without inversion RF pulse) according to the first embodiment of the present invention.

The basic data acquisition and processing steps according to the first embodiment of the present invention are schematically shown in Figures 2B and 3 and can be listed as follows:

1) Obtain (or at least read in) signal train $S_1$ from bSSFP measurement of the transient phase with inversion of the orientation of the material magnetization (see Figure 2B I, right)
2) Obtain (or at least read in) signal train $S_2$ from bSSFP measurement of the transient phase without inversion of the orientation of the material magnetization (see Figure 2B I, left)
3) Combine measured signal trains by performing a Combination COMB by adding measured signal trains in order to obtain the signal train $S_{add}$ (see Figure 2B II left) and by subtracting measured signal trains in order to obtain signal train $S_{sub}$ (see Figure 2B II, right) using Equations 5 and 6
4) Compute $T_1^*$ distribution as first transformation value $F_1 = F_{stst} = S_{stst}(T_1^*)$ for the added signal trains $S_{add}$, e.g. by inverse Laplace transform ILTF (see Figure 2B III, left)
5) Compute $T_1^*$ distribution as second transformation value $F_0 = S_0 (T_1^*)$ for subtracted signal trains $S_{sub}$, e.g. by inverse Laplace transform ILTF (see Figure 2B III, right)
6) For each $T_1^*$ value respectively transformation value , determine $S_0(T_1^*)$ from $F_0$ and $S_{stst}(T_1^*)$ from $F_1 = F_{stst}$ and compute the corresponding $M_0$, $T_1$ and $T_1$, $T_2$ values (see Figure 3) using Equations 2a, 2b and 2c.

In the example in Figure 2B, three tissue/material components can be identified within in the voxel. These three tissue types respectively material can be obtained by determining the Peaks Pk1, Pk2 and Pk3 in each of the $T_1^*$ spectra (which form the first and second transformation values), obtained by transforming the added signal trains $S_{add}$ respectively the subtracted signal trains $S_{sub}$ as depicted in the upper two diagrams of Figure 3. From the detected peaks Pk1, Pk2 and Pk3 the respective $T_1^*$ values can be determined at which the peaks as local maxima occur such that these respective $T_1^*$ values can be used to determine the $T_1$- and $T_2$-values according to the Equations 2a to 2c as mentioned previously. The correlated $T_1$-/$T_2$-values, which are derived from the peaks Pk1, Pk2 and Pk3, are displayed in the lower diagram of Figure 3. For these correlated $T_1$-/$T_2$-values an individual proton density $M_0$ can also be calculated according to the equation 2c mentioned previously. The determined correlated $T_1$-/$T_2$-values and proton density values can then for example be compared with known correlated $T_1$-/$T_2$-values and/or proton density values of several materials such that in the case of a predefined level of equality the material in the voxel can be identified as the material, which is allocated the detected correlated $T_1$-/$T_2$-value and/or proton density value resulted from the performed steps as mentioned above. The proton density is also used to determine the quantity of a specific material. In other words, $M_0$ tells us how much of the material is in the voxel.

This identification can be accomplished in a final step of specifying, in which the correlated $T_1$- and $T_2$- values for each component (respectively each material or at least one material) in the voxel under consideration can be computed according to Equations 2a-c and represented as a 2D spectrum, which is shown in Figure 3 at the bottom. The individual material can then for example be identified by comparison of the computed correlated $T_1$/$T_2$-values with predefined (expected) correlated $T_1$/$T_2$-values for a distinct material under consideration.

It is relevant to note, that spatial encoding can be applied by switching magnetic field gradients (as known from the state-of-the-art) between the RF- excitation pulses of the bSSFP sequence, e.g. using a Cartesian, a radial or a spiral readout. This allows to produce spatially resolved images at different time points during the transient phase.

Second embodiment:

In a second implementation or embodiment according to the present invention, two (or more) bSSFP signal trains are acquired where different excitation RF pulses that produce different flip angles $\alpha$, are employed.

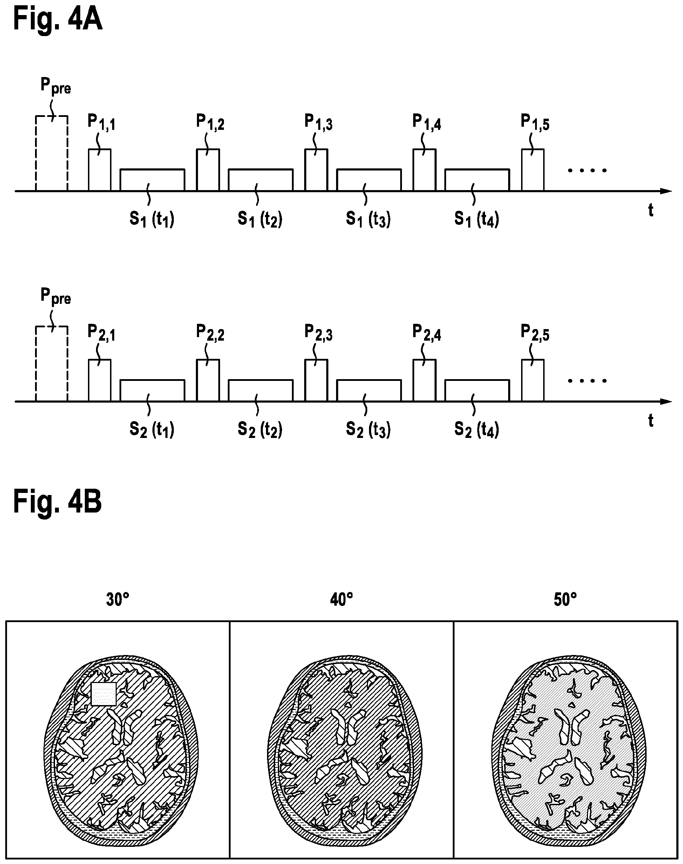

Figure 4A shows sequence diagrams for acquiring two signal trains $S_1$ and $S_2$ according to the second embodiment. In the first measurement (as shown in Figure 4A in the top diagram), radio-frequency excitation pulses $P_{1,n}$ (with n=1, ..., $N_{pulses}$ where $N_{pulses}$ represent the number of excitation pulses) producing flip angles $\alpha_{1,n}$ are applied to the material to generate the corresponding signals $S_1(t_n)$. In the second measurement (shown in the bottom diagram of Figure 4A), radio-frequency excitation pulses $P_{2,n}$ producing flip angles $\alpha_{2,n} \neq \alpha_{1,n}$ are applied to the material to generate the second signal train $S_2(t_n)$.

A magnetization preparation as for example performed by one or more radio-frequency preparation pulses $P_{pre}$ (e.g. one inversion pulse or one saturation pulse) may be applied before acquisition of the signal trains. The basic idea is to make use of the fact that $T_1^*$ depends on $T_1$, $T_2$ and the flip angle $\alpha$ produced by the excitation RF pulses

$$1/T_1^* = 1/T_1 \cdot \cos^2(\alpha/2) + 1/T_2 \cdot \sin^2(\alpha/2) \qquad \text{[Equation 7]}$$

For a series of N measurements (N>1) of different signal trains, this Equation can be rewritten:

$$1/T_{1,n}^* = 1/T_1 \cdot \cos^2(\alpha_n/2) + 1/T_2 \cdot \sin^2(\alpha_n/2) \qquad \text{with } n = 1,2,\ldots,N \qquad \text{[Equation 8]}$$

For two bSSFP measurements with different flip angles $\alpha_1$ and $\alpha_2$, each material component will have two different $T_1^*$ values within the corresponding $T_1^*$ spectra. Because $T_{1,n}^*$ can be determined from the spectrum (obtained from the corresponding signal train) and $\alpha_n$ is known from the instrument settings, $T_1$ and $T_1$, $T_2$ can be computed, because in this case there are two Equations ($T_{1,n}^*$ with n=1,2) and there are two unknowns ($T_1$ and $T_2$). In a more general way, Equation 8 may be rewritten in matrix form:

$$\mathbf{r}_1^* = \mathbf{T} \cdot \begin{pmatrix} 1/T_1 \\ 1/T_2 \end{pmatrix} \quad \text{with } \mathbf{T} = \begin{pmatrix} \cos^2(\alpha_1/2) & \sin^2(\alpha_1/2) \\ \vdots & \vdots \\ \cos^2(\alpha_N/2) & \sin^2(\alpha_N/2) \end{pmatrix} \text{ and } \mathbf{r}_1^* = \begin{pmatrix} 1/T_1^*(1) \\ \vdots \\ 1/T_1^*(N) \end{pmatrix} \quad \text{[Eq. 9]}$$

This matrix equation can be solved by computing the generalized inverse (pseudo-inverse, pinv) of the matrix T:

$$\begin{pmatrix} 1/T_1 \\ 1/T_2 \end{pmatrix} = \text{pinv}(\mathbf{T}) \cdot \mathbf{r}_1^* \qquad \text{[Equation 10]}$$

When $T_1$, $T_1$, $T_2$ and $\alpha$ are known, the relative proton density ($M_0$) can be computed for each peak using the relationship:

$$S_{stst} = S_0 \cdot \frac{\sin\alpha}{1 + \cos\alpha + (1 - \cos\alpha)(T_1/T_2)} \qquad \text{[Equation 11]}$$

Because the peak amplitude $F(T_1^*)$ in a $T_1^*$ spectrum is given by $S_0 + S_{stst}$, $S_0$ can be obtained from:

$$F = S_0 + S_{stst} = S_0 \cdot \left( 1 + \frac{\sin\alpha}{1 + \cos\alpha + (1 - \cos\alpha)(T_1/T_2)} \right) \qquad \text{[Equation 12]}$$

Finally, by combining Equations 2c and 12 the relative proton density of a specific peak is given by:

$$M_0 = \frac{F}{\sin\frac{\alpha}{2}} \cdot \left( 1 + \frac{\sin\alpha}{1 + \cos\alpha + (1 - \cos\alpha)(T_1/T_2)} \right)^{-1} \qquad \text{[Equation 13]}$$

Here, F is the measured peak amplitude in one $T_1^*$ spectrum and the corresponding $T_1$ and $T_1$, $T_2$ values

obtained from Equation 10.

The basic steps of the second embodiment of the present invention can be summarized as follows:

1) Perform (or at least read in) multiple bSSFP measurements of the transient phase with different flip angles $\alpha_n$, where n=1, ..., N and N is the number of measurements (N>1).

2) Generate (or perform a transformation in order to obtain) a $T_1^*$ spectrum for each measurement (e.g. by applying the inverse Laplace transform to the measured signal trains) and identify peaks in the spectra

3) Build up matrix **T** and the vector $r_1^*$ using the $T_{1,n}^*$ values from the corresponding peaks

4) Solve for $T_1$ and $T_1, T_2$ according to Equation 10

5) The relative proton density ($M_0$) may be computed for each peak according to Equation 13.

Analogous to our first implementation, spatial encoding can be applied during the measurements by switching magnetic field gradients between the RF-pulses of the bSSFP sequence, e.g. using a Cartesian, a radial or a spiral readout.

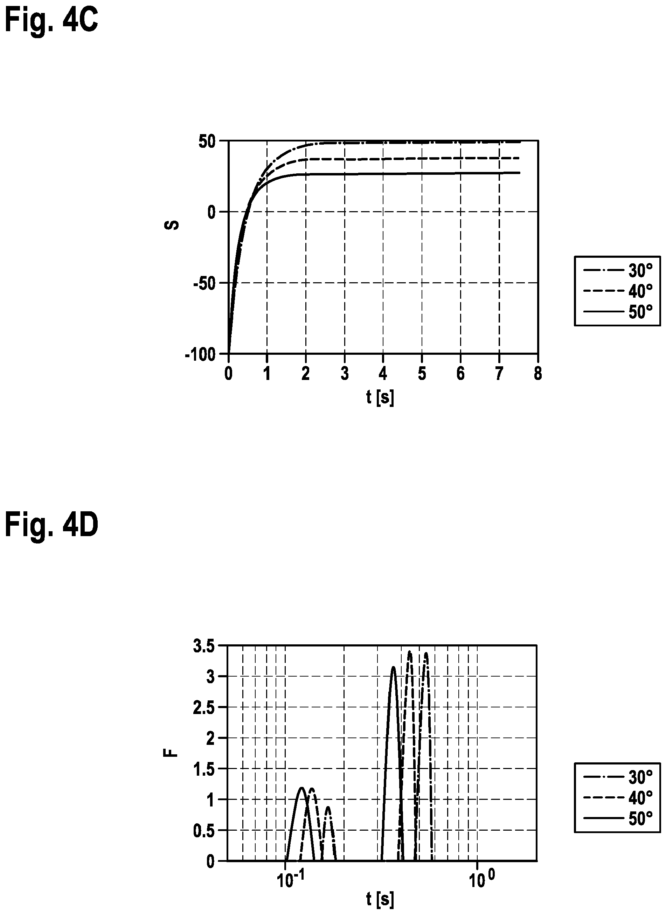

Figure 4 shows in three subfigures 4B, 4C and 4D results from a Proof-of-Principle measurement according to the second embodiment of the present invention. In-vivo measurements using IR-bSSFP with three different flip angles were performed on a clinical 3 Tesla MR system. A radial readout was used. In total, 1500 radial projections were acquired. 300 images were reconstructed with a sliding-window reconstruction to characterize the transient phase. Figure 4B shows the final images of the image series with three different flip angles. Figure 4C shows the signal trains from a small region of interest inside of the white brain matter (indicated by the white square in Figure 4B). The corresponding $T_1^*$ spectra are presented in Figure 4D. For each flip angle, two components can be identified in the corresponding $T_1^*$ spectra. The peaks for component 1 are $T_{1,1}^*(\alpha=30°) = 0.1682$ seconds, $T_{1,2}^*(\alpha=40°) = 0.1383$ seconds, $T_{1,3}^*(\alpha=50°) = 0.1225$ seconds. According to Equations 9 and 10 this corresponds to $T_1 = 0.21$ seconds, $T_1, T_2 = 0.029$ seconds assuming effective flip angles of $0.8 \cdot \alpha$. The peaks for component 2 are $T_{1,1}^*(\alpha=30°) = 0.523$ seconds, $T_{1,2}^*(\alpha=40°) = 0.4358$ seconds, $T_{1,3}^*(\alpha=50°) = 0.3632$ seconds. According to Equations 9 and 10 this corresponds to $T_1 = 0.71$ seconds, $T_1, T_2 = 0.078$ seconds assuming effective flip angles of $0.8 \cdot \alpha$. These initial results indicate a fast relaxing species (e.g. myelin) and a slow relaxing species (e.g. intra- and extracellular water pools).

The technical details of embodiments of the present invention can be mentioned as follows

- Two (or more) bSSFP signal trains of the transient phase are acquired where at least one sequence parameter is varied (e.g. flip angle of the RF excitation pulses or magnetization preparation pulses such as inversion).
- Spatial encoding may be performed by switching magnetic field gradients between the RF pulses to generate a series of images.
- A combination of at least two measured signal trains may be performed (e.g. by adding or subtracting the signal trains).
- Two (or more) one-dimensional $T_1^*$ spectra may be generated (e.g. by computing the inverse Laplace transform of the measured signal trains).
- Correlated $T_1$- and $T_2$- values and the corresponding relative proton densities ($M_0$) may be computed from the one-dimensional $T_1^*$ spectra.

The here disclosed method(s) allow(s) the quantification of correlated $T_1$- and $T_2$-values with only two measurements and represents a highly time efficient approach of identifying a material in a voxel. Compared to state-of-the-art IR-CPMG approach, the approach disclosed here is significantly faster and requires only several seconds scan time to produce correlated $T_1$- and $T_2$- values. Furthermore, the method is not based on a particular tissue model and therefore works for a wide range of biomedical applications at different organs.

The application fields of the proposed method are relatively broad and include e.g.

- Biomedical application: tissue characterization
- Clinical application: improved diagnostics with MR imaging (e.g. Myelin Mapping)
- Fast inline material testing and characterization of synthetic, biological or geophysical samples

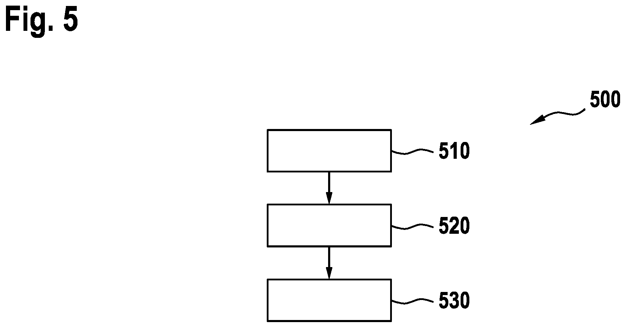

Figure 5 shows a flow diagram of a method 500 for identifying at least one material comprised in a voxel according to an embodiment of the present invention. The method 500 comprises a step 510 reading in at least a first and a second signal train, the first and second signal trains each representing magnetization values being determined after the material in the voxel was exposed to predefined radio-frequency pulses, wherein the predefined radio-frequency pulses exposed to the material in the voxel before or during measuring the first signal train differs in at least one parameter from the radio-frequency pulses exposed to the material in the voxel before or during measuring the second signal train. Furthermore, the method 500 comprises a step 520 of performing at least a time-domain-frequency-domain transformation in order to obtain a first and a second transformation value, the first transformation value representing a frequency domain signal resulting from the time-domain-frequency-domain transformation on the basis of at least the first signal and the second transformation value representing a frequency domain signal resulting from the time-domain-frequency-domain transformation on the basis of at least the second signal. Finally the method 500 comprises a step 530 of specifying the material using the first and/or second transformation values or values derived from the first and/or second transformation value, in order to identify the material.

**Claims**

1. Method (500) for identifying at least one material (115) comprised in a voxel (120), the method comprising the following steps:

   - Reading in (510) at least a first ($S_1$) and a second ($S_2$) signal train, the first ($S_1$) and second ($S_2$) signal train each representing magnetization values being determined after the material (115) in the voxel (120) was exposed to predefined radio-frequency pulses ($P_1$, $P_2$), wherein the predefined radio-frequency pulses ($P_1$) exposed to the material (115) in the voxel (120) before or during measuring the first signal train ($S_1$) differs in at least one parameter ($\alpha$) from the radio-frequency pulses ($P_2$) exposed to the material (115) in the voxel (120) before or during measuring the second signal train ($S_2$);
   - Performing (520) at least a time-domain-frequency-domain transformation (ILFT) in order to obtain a first ($F_1$) and a second ($F_0$) transformation value, the first transformation value ($F_1$) representing a frequency domain signal resulting from the time-domain-frequency-domain transformation on the basis of at least the first signal train ($S_1$) and the second transformation value ($F_0$) representing a frequency domain signal resulting from the time-domain-frequency-domain transformation on the basis of at least the second signal train ($S_2$); and
   - Specifying (530) the material (115) using the first ($F_1$) and second ($F_0$) transformation values or values derived from the first ($F_1$) and/or second ($F_0$) transformation value, in order to identify the material (115).

2. Method (500) according to claim 1, **characterized in that** in the step of Reading in (510) a second signal train ($S_2$) is read in, in which the parameter of the radio-frequency preparation pulse ($P_2$) exposed to the material (115) in the voxel (120) before measuring the second signal train ($S_2$) differs in an amplitude, a duration and/or an orientation from the radio-frequency preparation pulse ($P_1$) exposed to the material (115) in the voxel (120) before measuring the first signal train ($S_1$), especially in which the radio-frequency preparation pulse ($P_2$) exposed to the material (115) in the voxel (120) before measuring the second signal train ($S_2$) produces an magnetization of the material (115) in the voxel (120) with inverted sign as compared to the magnetization produced by radio-frequency preparation pulse ($P_1$) exposed to the material (115) in the voxel (120) for measuring the first signal train.

3. Method (500) according to claim 1, **characterized in that** in the step of Reading in (510) a second signal train ($S_2$) is read in, in which the parameter of the radio-frequency excitation pulses ($P_2$) exposed to the material (115) in the voxel (120) for measuring the second signal train ($S_2$) differs by a flip angle applied to a magnetization of the material (115) in the voxel (120) compared to the flip angles produced by radio-frequency excitation pulses ($P_1$) exposed to the material (115) in the voxel (120) for measuring the first signal train ($S_1$);

4. Method (500) according to one of the preceding claims, **characterized in that** the step of Performing (520) comprises performing a time-domain-frequency-domain transformation of terms obtained by a summation and/or a subtraction of the first ($S_1$) and second ($S_2$) signal train in order to obtain the first ($F_1$) and second ($F_0$) transformation values.

5. Method (500) according to one of the preceding claims, **characterized in that** the step of Performing (520) comprises performing an inverse Laplace Transformation and/or a Fourier Transformation, and/or **in that** the step of Performing (520) comprises performing a unidimensional time-domain-frequency-domain transformation.

6. Method (500) according to one of the preceding claims, **characterized in that** the step of Performing (520) comprises at least determining a local maximum of the first ($F_1$) and/or second ($F_0$) transformation value, especially determining a value ($T_1^*$), at which the local maximum of the first ($F_1$) and/or second ($F_0$) transformation value is obtained.

7. Method (500) according to one of the preceding claims, **characterized in that** the step of Performing (520) comprises a calculation of a longitudinal relaxation value ($T_1$) and a transverse relaxation value ($T_2$) on the basis of the first ($F_1$) and/or second ($F_0$) transformation values, especially on the basis of a value ($T_1^*$), at which the local maximum of the first ($F_1$) and/or second ($F_0$) transformation value is obtained.

8. Method (500) according to claim 7, **characterized in that** the step of Performing (520) comprises computing a inverse or pseudoinverse (pinv) of a matrix (**T**) comprising information about different flip angles ($\alpha$) of the radio-frequency excitation pulses ($P_1$, $P_2$) the material (115) of the voxel (120) is exposed to.

9. Method (500) according to one of claims 7 or 8, **characterized in that** the step of Specifying (530) comprises identifying the material (115) on the basis of at least one correlation of a longitudinal relaxation value ($T_1$) and a transverse relaxation value ($T_2$).

10. Method (500) according to one of the preceding claims, **characterized in that** the step of Specifying (530) comprises identifying the material (115) on the basis of a proton density value ($M_0$), being read in or being calculated from the first ($F_1$) and/or second ($F_0$) transformation values or values derived from the first ($F_1$) and/or second ($F_0$) transformation value.

11. Method (500) according to one of the preceding claims, **characterized in that** the step of Specifying (530) comprises identifying the material (115) on the basis of a signal train value ($S_{stst}$) in the steady state, a signal train value at the start ($S_0$) of the signal train and the a flip angles ($\alpha$) of the radio-frequency excitation pulses ($P_1$, $P_2$).

12. Apparatus (110) being configured for performing, controlling or executing the steps (510, 520, 530) of the method (500) according to one of the preceding claims in respective units (125, 130, 135).

13. Computer program, being configured for performing, controlling or executing the steps (510, 520, 530) of the method (500) according to one of the preceding claims, if the method (500) is executed on a respectively configured apparatus (110).

14. Machine readable data carrier comprising the computer program according to claim 13.

# Fig. 1

# Fig. 2A

# Fig. 2B

# Fig. 3

## Fig. 4A

## Fig. 4B

## Fig. 4C

## Fig. 4D

# Fig. 5

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUILIANG BAI ET AL: "Efficient 2D MRI relaxometry using compressed sensing", JOURNAL OF MAGNETIC RESONANCE, vol. 255, 11 April 2015 (2015-04-11), pages 88-99, XP055198210, ISSN: 1090-7807, DOI: 10.1016/j.jmr.2015.04.002 * subsection "2.1.4. 2D NMR of urea/water phantom" subsection "2.1.5. T1-T2 MRI of porcine spinal cord" first paragraph of subsection "2.2 Theory and data analysis" first paragraph of subsection "2.2.1. Preprocessing" first paragraph of subsection "2.2.5. Comparison" first paragraph of subsection "3.4. Porcine spinal cord ROI analysis"; figures 1a,1c, 8a * | 1-7,9, 12-14 | INV. G01R33/50 G01R33/561 |
| X | SEAN C.L. DEONI ET AL: "Gleaning multicomponent T1 and T2 information from steady-state imaging data", MAGNETIC RESONANCE IN MEDICINE., vol. 60, no. 6, 1 December 2008 (2008-12-01), pages 1372-1387, XP055317994, US ISSN: 0740-3194, DOI: 10.1002/mrm.21704 * p. 1372 left column last paragraph, p. 1373 left column last paragraph, section "Materials and methods" subsection "In Vivo experiments", section "Results" subsection "In Vivo Imaging Results" first paragraph; figures 3,4,5,6; tables 2,5 * | 1-3,5,7, 9,10, 12-14 | TECHNICAL FIELDS SEARCHED (IPC) G01R G01N A61B |

-/--

The present search report has been drawn up for all claims

| Place of search | Date of completion of the search | Examiner |
|---|---|---|
| Munich | 27 October 2017 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 17 16 5079

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG G ET AL: "Measuring T2 and T1, and imaging T2 without spin echoes", JOURNAL OF MAGNETIC RESONANCE, vol. 214, 7 December 2011 (2011-12-07), pages 273-280, XP028437251, ISSN: 1090-7807, DOI: 10.1016/J.JMR.2011.11.016 [retrieved on 2011-12-07] * Subsections "2.2 Tri-tau T2 and T1 measurements", "3.2 Phantom preparations", "3.3 NMR measurements". Last paragraph of subsection "4.2 Experiments" Last paragraph of section "5.Discussion"; figure 9 * | 1-7,9, 10,12-14 | |
| X | PETER SCHMITT ET AL: "Inversion recovery TrueFISP: Quantification of T1, T2, and spin density", MAGNETIC RESONANCE IN MEDICINE, JOHN WILEY & SONS, INC, US, vol. 51, no. 4, 1 April 2004 (2004-04-01), pages 661-667, XP002624779, ISSN: 0740-3194, DOI: 10.1002/MRM.20058 [retrieved on 2004-03-26] * Abstract section "Theory", second, fourth and fifth paragraph of section "Materials and methods", third and penultimate paragraph of section "Discussion"; table 1 * | 1,3,5, 7-14 | |

TECHNICAL FIELDS
SEARCHED    (IPC)

The present search report has been drawn up for all claims

| Place of search | Date of completion of the search | Examiner |
|---|---|---|
| Munich | 27 October 2017 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)